Europäisches Patentamt

European Patent Office

Office européen des brevets

(11) Publication number: **0 435 326 A2**

# EUROPEAN PATENT APPLICATION

(21) Application number: 90125693.3

(22) Date of filing: 28.12.90

(51) Int. Cl.⁵: **H05K 13/08**, H05K 13/00, H01L 21/00

(30) Priority: 29.12.89 JP 343970/89

(43) Date of publication of application:
**03.07.91 Bulletin 91/27**

(84) Designated Contracting States:
**AT BE CH DE DK ES FR GB GR IT LI NL SE**

(71) Applicant: OMRON CORPORATION
10, Tsuchido-cho Hanazono Ukyo-ku
Kyoto 616(JP)

(72) Inventor: Kobayashi, Shigeki
Kishinoshita-cho, Nishino
Yamashina-ku, Kyoto(JP)
Inventor: Tanaka, Koichi
Kitakawaramachi, Matsumuro
Nishikyo-ku, Kyoto(JP)

(74) Representative: WILHELMS, KILIAN &
PARTNER Patentanwälte
Eduard-Schmid-Strasse 2
W-8000 München 90(DE)

(54) Circuit board inspection device.

(57) This apparatus and method distinguish component leads which have been defectively inserted through holes in printed circuit boards from properly inserted ones on the basis of an imaging pattern. The pattern is produced by projecting different colors of light onto the parts of the circuit board where the leads are inserted in such a way that the light illuminates the board at different angles of incidence. The leads are inspected automatically as to proper insertion on the basis of patterns in polar coordinates generated from the imaging data.

EP 0 435 326 A2

## CIRCUIT BOARD INSPECTION DEVICE

### FIELD OF THE INVENTION

This invention relates to a device for automated inspection of components mounted on printed circuits board to verify that the components are mounted properly. More particularly, the invention relates to an apparatus which inspects whether or not the lead of a component has been properly inserted through the lead hole in the circuit board.

### BACKGROUND OF THE INVENTION

Through holes for lead insertion are provided at every location on a printed circuit board where a component with a lead is to be inserted. Around these holes, electrode patterns, called "lands", are stamped. In order to package components on this type of board, the leads of the component to be mounted are inserted through the appropriate holes and the ends of the leads are allowed to protrude over the lands. Solder is then applied between the protruding end of the each lead and the corresponding lands in order to fix the component to the board.

When the lead has been inserted through the hole, the end of the lead is trimmed so that the protruding portion is of a specified length. Next, the protruding portion is bent at an angle so that the component will be temporarily secured to the board. Then the board is turned over so that the component can be inspected.

If the lead is not properly inserted through the lead hole or does not protrude sufficiently, the soldering will be faulty and the component will have been packaged defectively. And if the protruding portion of the lead is not bent securely, the lead may come out of the lead hole when the board is turned over to be inspected, and the component may fall out of the board entirely.

Thus it is necessary, before the soldering operation is commenced, to inspect whether or not the lead of each component which is to be packaged is properly inserted through its hole. Previously, this inspection was generally done by human eye. However, it was unavoidable that mistakes would occur with this type of visual inspection. Judgments of acceptability varied from person to person, and there were limits to the ability of people to perform such inspections.

### SUMMARY OF THE INVENTION

In view of these problems, a feature of this invention is to provide an inspection device for printed circuit boards which can detect, reliably and swiftly, whether a lead is properly inserted through its hole on the circuit board. The apparatus of this invention includes multiple annular light sources which emit light of various hues, each at a different angle of incidence to the board, on the area where the lead is inserted and on the side of the board from which it protrudes; an imaging device to form an image from the various hues of light reflected off the area where the lead is inserted; and a judgment processor to determine from the pattern obtained by the imaging device whether or not the lead is properly inserted.

Light of a different hue is emitted by each of the annular light sources and illuminates the area where the lead is inserted at different angles of incidence. When the light reflected from the lead and circuit board is imaged with the imaging device, the lead hole appears dark because it does not reflect any light to the imager. Because the lead and the electrode pattern on the surface of the board have different angles of inclination, each will reflect light of a different hue toward the imager. Thus, the pattern produced by the imager can easily be used to distinguish whether a lead is properly or improperly inserted. This enables a swift and reliable inspection of the circuit board.

### BRIEF DESCRIPTION OF THE DRAWINGS

Fig. 1 is a block diagram of a sample circuit board inspection device in which this invention has been implemented. Fig. 2 is a series of diagrams showing imaged patterns of the part where the lead is inserted and the projection pattern produced in polar coordinates.

FIGS. 3 and 4 are flow charts of the inspection procedure in accordance with this invention.

FIGS. 5 and 6 are diagrams illustrating the operating principles of this invention.

### DETAILED DESCRIPTION OF THE INVENTION

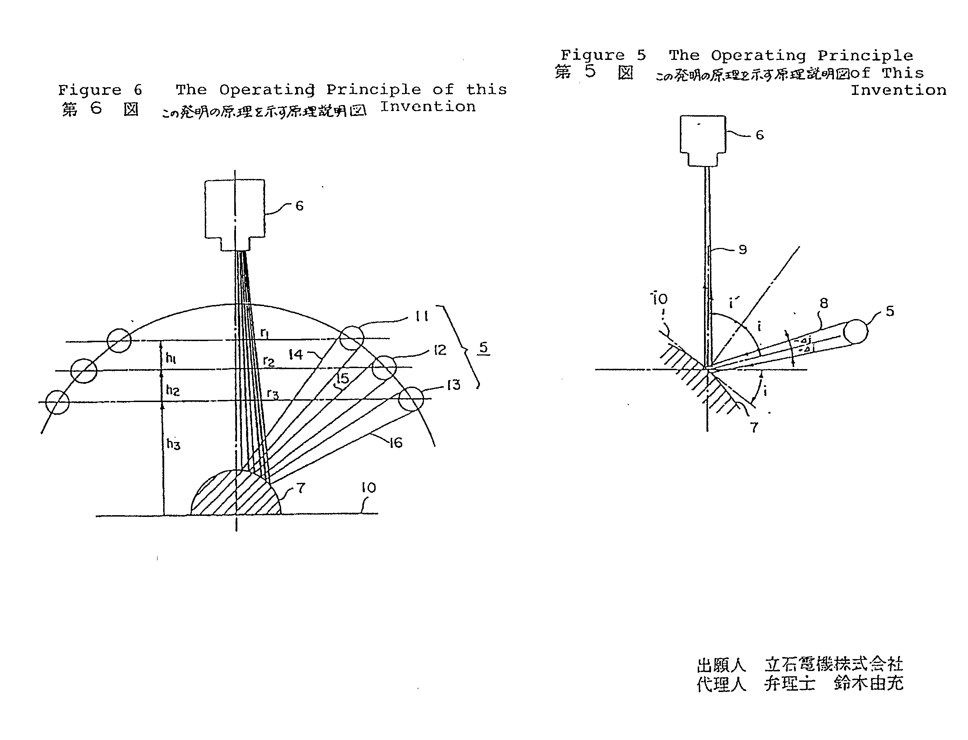

FIG. 5 shows the positional relationship between the detection system, which includes light source 5 and imaging device 6, and inspection area 7. With reference to the same diagram, light flux 8 from light source 5 illuminates the surface of inspection area 7 at incident angle i. Reflected light flux 9 then enters imaging device 6, which is directly above the area to be inspected, at angle i' (which is equal to i), and is detected by the imaging device. The curved portion of inspection area 7, which is irradiated by light flux 8, is detected as lying at angle i with respect to reference plane 10.

If light source 5 emits light flux 8 of width $2\Delta i$

and illuminates the surface at an angle of incidence ranging from i + Δi to i - Δi, reflected light flux 9 of a corresponding width will be detected by imaging device 6. That is to say, an element of a curved surface having an angular width of i + Δi to i - Δi with respect to reference plane 10 will be detected.

If the annular light sources 5 are placed horizontally with respect to reference plane 10, as shown in FIG. 6, and inspection area 7 is situated on the center line of the annuli, then the distances between light sources 5 and inspection area 7 are independent of the rotational angle of inspection area 7 with respect to an axis perpendicular to reference plane 10. Thus any effects due to the angular orientations of the curved surface elements will be cancelled out. As a result, only the angle of inclination with respect to reference plane 10 will be detected.

If light source 5 is composed of multiple annular light sources 11, 12 and 13, whose fluxes will have different angles of incidence with respect to detection area 7, as shown in FIG. 6, then curved surface elements will be detected which have orientations corresponding to the angles of incidence of light fluxes 14, 15 and 16 from the light sources. If light sources are used for 11, 12 and 13 which emit light of different hues, then detection data from curved surface elements having different angles of orientation can be distinguished without resorting to separate processing for each angle.

Let us assume that the three annular light sources 11, 12 and 13 of radii $r_n$ (n = 1, 2, and 3) are disposed horizontally at heights $h_n$ (n = 1, 2, and 3) from reference plane 10. The angles of incidence of light fluxes 14, 15 and 16 with respect to inspection area 7 will then be $i_n$ (n = 1, 2 and 3). Under these conditions, curved surface elements whose respective angles of inclination at inspection area 7 are $i_n$ will be detectable by imaging device 6. In comparison with the lengths of the optical paths from light sources 11, 12 and 13 to imaging device 6 via the surface of detection area 7, the curved surface elements are small enough so that their angles of incidence, that is, the angles of inclination of the curved surface elements which are to be detected, can be determined by the following equation.

$$\cos i_n = \frac{h_n}{\sqrt{h_n{}^2 + r_n{}^2}}$$

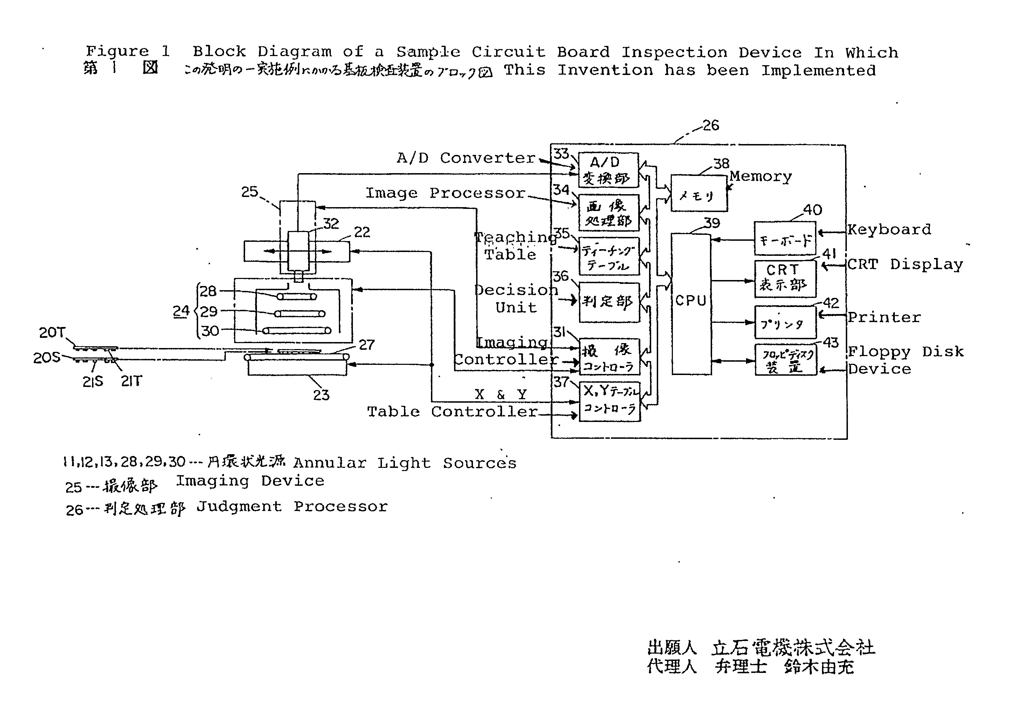

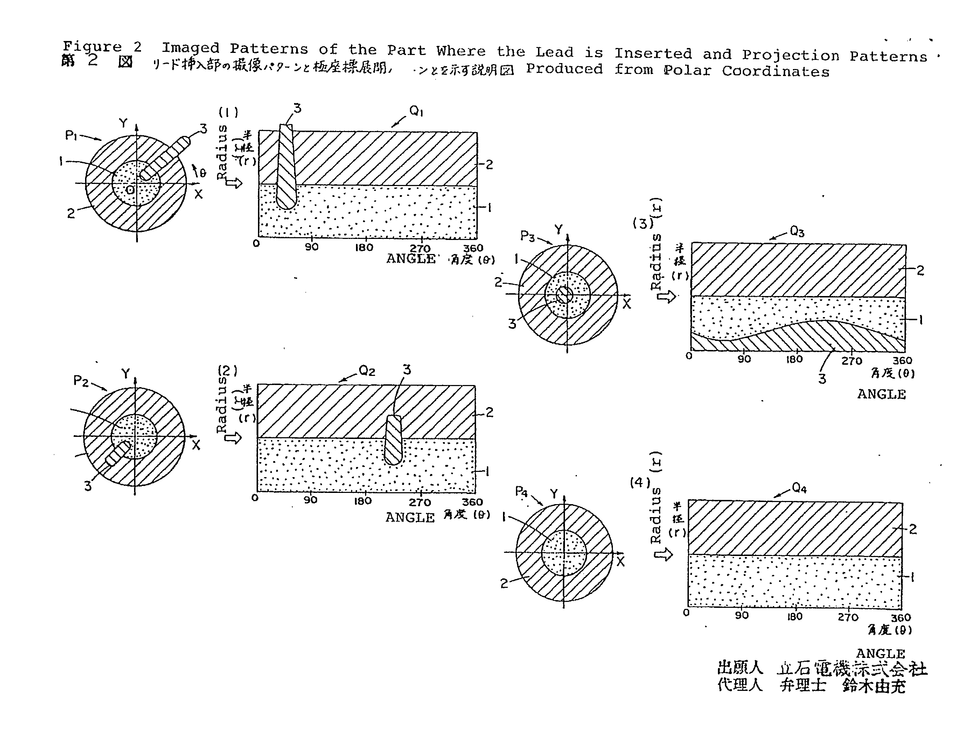

FIGS. 1 and 2 show how this invention can be implemented based on the principle explained above. The detection system comprises light source 24, composed of the three annular light sources 23, 29 and 30, of different diameters and situated at different heights; and imaging device 25, composed of a single color television camera placed directly above the object to be inspected, on the center line of the annular light sources. Annular light sources 28, 29 and 30 irradiate the object to be detected with different hues of light (in this example, red, green and blue) at different angles of incidence. Imaging device 25 includes color television camera 32, which can detect curved surface elements with inclinations corresponding to the angles of incidence of the flux from each of the light sources.

This inspection device for circuit boards detects whether or not the lead of each of components 21T is properly inserted through its lead hole in the circuit board. It does this by imaging positioning board 20S and the object of inspection, circuit board 20T. It then compares the parameters (judgment data) of each of the component inspection areas 21S are on the surface of positioning board 20S, with the parameters (inspection data) of each of component 21T's inspection areas, which are on the surface of the said object of inspection, circuit board 20T. The inspection device includes X-axis stage 22 and Y-axis stage 23, each of which has a drive motor (not shown) to move the stages in accordance with control signals from judgment processor 26. The drive provided by these motors causes X-axis stage 22 to move imaging unit 25 in the X direction, and causes Y-axis stage 23 to move conveyor 27, which supports circuit boards 20S and 20T, in the Y direction. Circuit boards 20S and 20T are irradiated by the light from source 24 and imaged by imaging device 25.

Light source 24 has three annular light sources, 28, 29 and 30. These light sources generate red, green and blue light, respectively, based on control signals from judgment processor 26. Circuit boards 20S and 20T are irradiated by a mixture of the three colors of light. In our example, light sources 28, 29 and 30 are constructed by attaching red, green and blue transparent panels to white light sources.

Light source 24 is designed so that pure white light results when the three colors of light emitted by light sources 28, 29 and 30 are mixed, and so that information relating to components on circuit boards 20S and 20T (part number, polarity, color code, etc.) and information concerning the pattern on the board (various marks and the like) can be read under its illumination. In other words, light sources 28, 29 and 30 emit red, green and blue light spectra respectively, and each spectrum has a light emission energy distribution such that white light will result when they are mixed. The quantity of light emitted by light sources 28, 29 and 30 is adjusted by imaging controller 31 so that the mixture of red, green and blue light will yield white light.

Imaging device 25 is equipped with color television camera 32, which is positioned above light source 24. Camera 32 receives the light reflected off circuit boards 20S and 20T, converts it into color video signals R, G and B, and supplies these signals to judgment processor 26.

Judgment processor 26 comprises A/D converter 33, memory 38, teaching table 35, image processor 34, decision unit 36, X and Y stage controller 37, imaging controller 31, CRT display unit 41, printer 42, keyboard 40, floppy disk device 43, and controller (CPU) 39. In inspection mode, the processor processes the color video signals R, G and B derived from the image of the board being inspected, circuit board 20T. It detects the pattern of each hue in every inspection area for every component 21T on the circuit board. It then generates parameters and creates a file of inspection data. The processor compares this inspection data file with a reference file, and makes an automatic judgment, based on the result of this comparison, as to whether the leads of specified components 21T are properly inserted through the holes in circuit board 20T.

The left-hand views in each of FIGS. 2 (1) through (4) show patterns $P_1$ through $P_4$ produced by imaging device 25. The imaging device produced these patterns by photographing the lead holes in circuit board 20T from the back of the board. (The side on which the components are packaged will be referred to as the front.) FIG. 2 (1) shows imaging pattern $P_1$ resulting from a lead properly inserted into a lead hole. FIGS. 2 (2) through (4) show imaging patterns $P_2$ through $P_4$ resulting from leads improperly inserted through lead holes.

In the same FIGS., the regions labeled "1" are the dark areas which do not reflect light. These portions of the image correspond to the lead holes. The regions labeled "2" are the areas which reflect red light (hereafter referred to as "red areas"). They correspond to the lands. The regions labeled "3" are the areas which reflect blue light (hereafter, "blue areas"). These correspond to the leads.

If the lead is properly inserted, that is, if it protrudes sufficiently and its protruding segment is securely bent, the imaging pattern (shown in FIG. 2 (1)) will show blue area 3 completely intersecting annular red area 2 in a radial direction. If the lead does not protrude enough or is not sufficiently bent, the imaging pattern (shown in FIG. 2 (2)) will show blue area 3 as enclosed within annular red area 2 rather than intersecting it completely in a radial direction. If the lead is not bent at all, the imaging pattern (shown in FIG. 2 (3)) will show blue area 3 completely enclosed within dark area 1 with no part of it in red area 2. And if the lead is not inserted into the lead hole, the imaging pattern (shown in FIG. 2 (4)) will show the entire center as dark with no blue area at all.

Because there are clear differences between the pattern imaged from a properly inserted lead and that imaged from an improperly inserted one, the imaging pattern can be used to distinguish whether or not a lead is properly inserted. More concretely, the imaging device observes the entire periphery of red area 2. If red area 2 is completely intersected by blue area 3, it makes the judgment that the lead is properly inserted. If the relationship between the red and blue areas is anything other than this, it makes the judgment that the lead is not properly inserted.

Returning now to FIG. 1, imaging device 25 supplies color signals R, G and B to A/D converter 33, which digitizes them and outputs them to control unit 39. Memory 38 has a RAM which is used as a working area for control unit 39. Image processor 34 processes the image data supplied via control unit 39, creates an inspection data file and a reference file, and supplies these files to control unit 39 and decision unit 36.

Image processor 34 projects image patterns $P_1$ through $P_4$, shown on the left side of FIGS. 2 (1) through (4), into polar coordinates. It then uses these coordinates to create the inspection data file, which requires polar coordinate patterns $Q_1$ through $Q_4$, shown on the right sides of FIGS. 2 (1) through (4), respectively. This allows the postprocessing operation to be performed swiftly and allows a smaller capacity memory to be used.

In the aforementioned projection into polar coordinates, an XY coordinate system is defined using the center of the lead hole as the point of origin, 0. If $Y = 0$ and $X \geq 0$ and the angle of the x axis $\theta = 0°$, then we can use the following equations to convert this system to an $r - \theta$ coordinate system (with r being the radius) rotated $360°$ counterclockwise.

$$X = r \cos \theta$$
$$Y = r \sin \theta$$

The polar coordinate patterns $Q_1$ through $Q_4$ can be used to determine, in a simple fashion and without regard to the angular position of the lead, whether the protruding portion of the lead is bent sufficiently before it reaches the outer perimeter of the land.

In the teaching operation, control unit 39 supplies a reference file to teaching table 35. This file is stored, and when control unit 39 outputs a request to send during the inspection operation, the file is read out in response to the request and supplied to control unit 39 and decision unit 36.

In the inspection operation, decision unit 36 compares the inspection file sent from image processor 34 with the reference file supplied by control unit 39. It then judges whether or not the leads are properly inserted through their holes on the board being inspected, circuit board 20T, and supplies its decision to control unit 39.

Imaging controller 31 is connected via interfaces to control unit 39, light source 24 and imaging device 25. It regulates the intensity of light emitted by each of light sources 28, 29 and 30 in light source 24 according to output from control unit 39. It also balances the three color video signals from television camera 32 in imaging device 25.

X and Y stage controllers 37 are connected via interfaces to control unit 39 and to X stage 22 and Y stage 23. They control the X and Y stages based on output from control unit 39.

CRT display 41 has a cathode ray tube (CRT) in it. when image data, acceptability decisions, or keyed-in input data are supplied by control unit 39, it displays them on its screen. Printer 42 is supplied with acceptability decisions and the like by control unit 39. It prints these out in a predetermined format. Keyboard 40 is equipped with the various keys necessary to input operating information as well as data concerning reference board 20S and circuit board 20T, the board being inspected. The information and data entered via keyboard 40 are supplied to control unit 39.

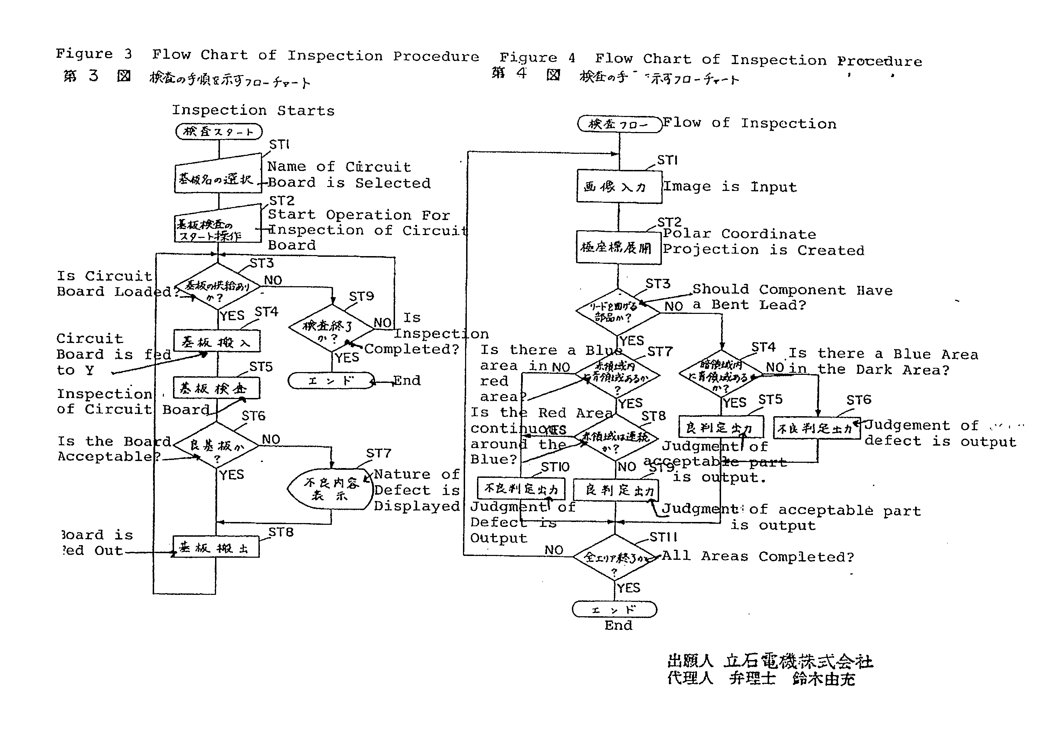

Control unit 39 has a microprocessor which allows it to control the sequential inspection operations, which are carried out in the order depicted in FIGS. 3 and 4. With the design described above, a number of parameters must be taught using reference board 20S before the circuit board 20T can be inspected. These include the colors used in the image for the lead hole, the lead and the land; the position of the component (the position of the lead); the type of component; the dimensions of the land; and the area to be inspected. A reference file is created from these taught data and stored in teaching table 35. Once teaching has been completed, the inspection device is ready to perform an automatic inspection of circuit board 20T.

First, the operator switches the device into inspection mode, as shown in FIG. 3. In steps 1 and 2 [labeled "ST1" and "ST2" in the drawings in the interest of brevity], the name of the board to be inspected is selected and the Start operation for the inspection is carried out.

In step 3, a check is made as to whether circuit board 20T is in the inspection device. If the decision is "YES", conveyor 27 operates to bring circuit board 20T to Y-axis stage 23, and the inspection starts (steps 4 and 5).

In step 5, control unit 39 controls X-axis stage 22 and Y-axis stage 23 in such a way that the first component on the board under inspection, component 21T, is in the field of vision of television camera 32. The camera images that component and automatically extracts the portion of the inspection area where the lead is inserted. It calculates the parameters of this portion and uses them to create an inspection data file. Control unit 39 sends this data file to decision unit 36, which compares it with its reference file. It then renders a judgment as to whether the lead of component 21T is properly inserted through the lead hole.

This same inspection is performed on each component 21T on circuit board 20T, one after another. If an insertion defect is found, the defective component and the nature of the defect will be displayed on CRT display 41 or printed out by printer 42. Circuit board 20T will then be removed from the inspection device. (Steps 7 and 8) When this inspection procedure has been performed on all the circuit boards 20T chosen for inspection, the decision in Step 9 will be "YES", and the inspection will be completed.

FIG. 4 shows the details of the inspection procedure performed in Step 5 of FIG. 3. In Step 1 of FIG. 4, the image of the part of the board where the lead is inserted is input. In Step 2, the imaged pattern is assigned polar coordinates and a polar coordinate pattern is generated.

In Step 3, a decision is made as to whether the component being inspected is of the type which is temporarily secured by bending the lead. If the decision is "NO", the inspection proceeds to Step 4, and a decision is made as to whether there is a blue area (the image of the lead) within the dark area (the image of the lead hole) in the pattern developed from the polar coordinates. If there is, the decision in Step 4 will be "YES", and the judgment will be output that the lead is properly inserted in this hole. (Step 5) If there is no blue area within the dark area, the decision in Step 4 will be "NO", and the judgment will be output that the lead is defectively inserted in this hole. (Step 6)

If the decision made in the Step 3 of FIG. 4 is that the component to be inspected is the type which is temporarily secured by bending the lead (if the decision in Step 3 is "YES"), the inspection proceeds immediately to Step 7. A decision is then made as to whether there is a blue area (the image of the lead) within the red area (the image of the land) in the pattern developed in polar coordinates. If there is, a decision will be made in Step 8 as to whether this red area (the image of the land) totally surrounds the blue area. If the red area is completely intersected by the blue area, the decision in Step 8 will be "NO", and the judgment will be output that the lead is properly inserted through this hole. (Step 9)

If there is no blue area within the red area, the decision in Step 7 will be "NO", and it will be concluded that the lead is not bent. This will cause the judgment to be output that the lead is defectively inserted through this hole. (Step 10) If there is a blue area within the red area, but the red area is not completely intersected by the blue, the decision in Step 8 will be "YES", and it will be concluded that the lead does not protrude enough or is not sufficiently bent. This will cause the judgment to be output that the lead is defectively inserted through this hole. (Step 9)

When this procedure has been performed on all the components, the decision in Step 11 will be "YES", and the circuit board inspection procedure will be completed.

Persons skilled in this art will recognize other equivalent apparatus and methods for carrying out this invention from our description of it above and from the claims appended hereto.

## Claims

1. An apparatus for determining whether a lead is properly inserted through a hole in a printed circuit board, comprising:
   holding means for holding the printed circuit board in an inspection area of the apparatus;
   a plurality of light sources, each emitting light of a different hue, directed at different angles of incidence to an area on said printed circuit board through which said lead is to emerge after insertion;
   imaging means for forming an image from the different hues of light reflected from said area on said printed circuit board; and
   judgment means for determining from said image whether the lead is properly inserted through the hole in the printed circuit board.

2. An apparatus for determining whether a lead is properly inserted through a hole in a printed circuit board according to claim 1, having three of said light sources which are annular in configuration.

3. An apparatus for determining whether a lead is properly inserted through a hole in a printed circuit board according to claim 1, wherein said imaging means comprises a color television camera.

4. An apparatus for determining whether a lead is properly inserted through a hole in a printed circuit board according to claim 1, further comprising moving means for moving an X-axis stage and a Y-axis stage, and wherein the judgment means outputs control signals which drive motors to move said X-axis and Y-axis stages in accordance with said control signals.

5. An apparatus for determining whether a lead is properly inserted through a hole in a printed circuit board according to claim 4, wherein motion of said X-axis stage by said moving means moves the imaging means in an X-direction, and wherein motion of said Y-axis stage by said moving means moves the holding means in a Y-direction.

6. An apparatus for determining whether a lead is properly inserted through a hole in a printed circuit board according to claim 3, wherein said different hues are red, green and blue.

7. An apparatus for determining whether a lead is properly inserted through a hole in a printed circuit board according to claim 1, wherein said judgment means comprises means for detecting patterns from video signals comprising said image for each hue reflected from each of said areas on said printed circuit board through which a lead is to emerge after insertion, means for generating parameters from said patterns, means for creating an inspection data file containing said parameters, means for comparing the inspection data file with a reference file and means for making a judgment as to whether leads are properly inserted through the holes in said printed circuit board based on the result of comparing the inspection data file with the reference file.

8. An apparatus for determining whether a lead is properly inserted through a hole in a printed circuit board according to claim 1, wherein said judgment means comprises means for detecting patterns from video signals comprising said image for each hue reflected from each of said areas on said printed circuit board through which a lead is to emerge after insertion and means for projecting said patterns into polar coordinates.

9. An apparatus for determining whether a lead is properly inserted through a hole in a printed circuit board according to claim 8, wherein said judgment means further comprises means for creating an inspection data file containing said polar coordinates of said patterns, means for comparing the inspection data file with a reference file and means for making a judgment as to whether leads are properly inserted through the holes in said printed circuit board based on the result of comparing the inspection data file with the reference file.

10. A method for determining whether a lead is properly inserted through a hole in a printed circuit board, comprising:

holding the printed circuit board in an inspection area of the apparatus;

providing a plurality of light sources, each emitting light of a different hue, and directing said plurality of light sources at different angles of incidence to an area on said printed circuit board through which said lead is to emerge after insertion;

forming an image from the different hues of light reflected from said area on said printed circuit board; and

determining from said image whether the lead is properly inserted through the hole in the printed circuit board.

11. A method for determining whether a lead is properly inserted through a hole in a printed circuit board according to claim 10, wherein three light sources are directed at said printed circuit board.

12. A method for determining whether a lead is properly inserted through a hole in a printed circuit board according to claim 10, wherein said imaging is carried out with a color television camera.

13. A method for determining whether a lead is properly inserted through a hole in a printed circuit board according to claim 12, wherein said different hues are red, green and blue.

14. A method for determining whether a lead is properly inserted through a hole in a printed circuit board according to claim 10, wherein said determining comprises

detecting patterns from video signals comprising said image for each hue reflected from each of said areas on said printed circuit board through which a lead is to emerge after insertion,

generating parameters from said patterns,

creating an inspection data file containing said parameters,

comparing the inspection data file with a reference file, and

making a judgment as to whether leads are properly inserted through the holes in said printed circuit board based on the result of comparing the inspection data file with the reference file.

15. A method for determining whether a lead is properly inserted through a hole in a printed circuit board according to claim 10, wherein said detecting comprises

detecting patterns from video signals comprising said image for each hue reflected from each of said areas on said printed circuit board through which a lead is to emerge after insertion, and

projecting said patterns into polar coordinates.

16. A method for determining whether a lead is properly inserted through a hole in a printed circuit board according to claim 15, wherein said determining further comprises

creating an inspection data file containing said polar coordinates of said patterns,

comparing, the inspection data file with a reference file, and making a judgment as to whether leads are properly inserted through the holes in said printed circuit board based on the result of comparing the inspection data file with the reference file.

Figure 1  Block Diagram of a Sample Circuit Board Inspection Device In Which

第 1 図 この発明の一実施例にかかる基板検査装置のブロック図 This Invention has been Implemented

A/D Converter — 33 A/D 変換部

Image Processor — 34 画像処理部

Teaching Table — 35 ティーチングテーブル

Decision Unit — 36 判定部

Imaging Controller — 31 撮像コントローラ

X & Y Table Controller — 37 X,Yテーブルコントローラ

26

38 メモリ Memory

39 CPU

40 キーボード Keyboard

41 CRT 表示部 CRT Display

42 プリンタ Printer

43 フロッピディスク装置 Floppy Disk Device

11,12,13,28,29,30 --- 円環状光源 Annular Light Sources

25 --- 撮像部  Imaging Device

26 --- 判定処理部 Judgment Processor

出願人 立石電機株式会社
代理人 弁理士 鈴木由充

EP 0 435 326 A2

Figure 2 Imaged Patterns of the Part Where the Lead is Inserted and Projection Patterns
第 2 図 リード挿入部の撮像パターンと極座標展開 / ・ンとを示す説明図 Produced from Polar Coordinates

出願人　立石電機株式会社
代理人　弁理士　鈴木由充

EP 0 435 326 A2

Figure 3  Flow Chart of Inspection Procedure

第 3 図  検査の手順を示すフローチャート

Inspection Starts

検査スタート

ST1 — 基板名の選択 — Name of Circuit Board is Selected

ST2 — 基板検査のスタート操作 — Start Operation For Inspection of Circuit Board

ST3 — 基板の状給ありか？ — Is Circuit Board Loaded?  NO

ST4 — 基板搬入 — Circuit Board is fed to Y  YES

ST5 — 基板検査 — Inspection of Circuit Board

ST6 — 良基板か？ — Is the Board Acceptable?  NO / YES

ST7 — 不良内容表示 — Nature of Defect is Displayed

ST8 — 基板搬出 — Board is fed Out

ST9 — 検査終了か？ — Is Inspection Completed?  NO / YES

エンド — End

---

Figure 4  Flow Chart of Inspection Procedure

第 4 図  検査の手順を示すフローチャート

検査フロー — Flow of Inspection

ST1 — 画像入力 — Image is Input

ST2 — 極座標展開 — Polar Coordinate Projection is Created

ST3 — リードを曲げる部品か？ — Should Component Have a Bent Lead?  NO / YES

ST4 — 暗領域内に青領域あるか？ — Is there a Blue Area in the Dark Area?  NO / YES

ST7 — 赤領域内に青領域あるか？ — Is there a Blue area in red area?  NO / YES

ST8 — 赤領域は連続か？ — Is the Red Area continuous around the Blue?  YES / NO

ST5 — 良判定出力 — Judgment of acceptable part is output.

ST6 — 不良判定出力 — Judgement of defect is output

ST9 — 良判定出力 — Judgment of acceptable part is output

ST10 — 不良判定出力 — Judgment of Defect is Output

ST11 — 全エリア終了か？ — All Areas Completed?  NO / YES

エンド — End

出願人  立石電機株式会社
代理人  弁理士  鈴木由充

EP 0 435 326 A2

10

Figure 6    The Operating Principle of this
第 6 図    この発明の原理を示す原理説明図 Invention

Figure 5    The Operating Principle
第 5 図    この発明の原理を示す原理説明図of This
                                                    Invention

出願人　立石電機株式会社
代理人　弁理士　鈴木由充

EP 0 435 326 A2